# EUROPEAN PATENT APPLICATION

(11) **EP 4 502 107 A1**
(43) Date of publication of application: **05.02.2025**
(21) Application number: 23189570.7
(22) Date of filing: 03.08.2023
(51) Int. Cl.: C09K 11/80, H01L 33/50, C04B 35/44

(54) **PHOSPHORS FOR HIGH-POWER APPLICATIONS**

(71) Applicant: Seaborough IP I B.V., 1098 XG Amsterdam (NL)
(72) Inventor: SONTAKKE, Atul Dnyaneshwar, 1363 BL Almere (NL); KHANIN, Vasilii Mikhailovich, 1096 HV Amsterdam (NL); VAN DER HAAR, Marie Anne, 1381 HL Weesp (NL)
(74) Representative: Hoyng Rokh Monegier B.V.

(57) **Abstract**

The present invention provides an improved luminescent composition for high-power lighting applications. There is provided a phosphor ceramic comprising a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1, and wherein 0≤w<1. There is also provided a method for producing such a phosphor ceramic comprising the steps of:
a. providing a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1; and wherein 0≤w<1;
b. forming it into a shape; and
c. sintering the formed shape.

## Description

### Field of the invention

The present invention provides an improved luminescent composition for high-power lighting applications.

### Background of the invention

For high power lighting applications, with light intensities well above 1 W/mm², it is a struggle to find suitable color converting materials.

Not every material is suitable to produce in the required form compatible with high-power lighting devices. While normal white LEDs use green and red phosphors in a resin matrix, resin is not a good heat conductor, and furthermore is susceptible to melting or degrading at elevated temperatures. The generated heat in high-power applications thus makes this approach unsuitable for high-power applications.

Some phosphor materials are also simply not able to process the high light fluxes fast enough. Moreover, due to the heat generated by the high light intensity, many materials may simply break down, and/or suffer from severe temperature quenching. The very limited amount of available suitable phosphors for these devices does not only limit the performance, but has also resulted in slow market penetration of solid state lighting applications for high power applications.

One class of materials that can be used for high-power applications are Ce-doped garnets (e.g. "YAG:Ce" or "LuAG:Ce") phosphors in ceramic form. These phosphors yield broad band yellow/green emission, that may be used to produce cold white light. The ceramic material is both more heat stable and better at conducting heat than resin. However, while yellow/green emission is doable, finding a compatible red emitter has been proven to be much more challenging. In fact, no red material ceramic is currently available, and the most commonly used solution is to use the small fraction of red light emitted by YAG:Ce. This is a very energy inefficient approach, as it requires undesired emission to be filtered out.

Other approaches for providing red emission include Eu²⁺-doped nitride phosphors. However, at high light intensity, the photo-thermal quenching causes the quantum yield to be very low. The material also degrades at a fast rate due to the generated heat. Furthermore, Eu²⁺-doped nitride phosphors cannot be combined within a ceramic with YAG:Ce. To overcome these issues, the phosphor-in-glass method has been explored, wherein the powder phosphors are suspended in a glass matrix. While glass is more stable to heat than resin, it has a lower thermal conductivity than ceramics. Furthermore, the packing density of the phosphors is lower in this approach, resulting in weaker emission.

US2019/0367809 discloses a fluorescent powder material and light emitting device. -

Thus, there remains a need for red emitting phosphor materials for high-power applications.

### Description of the Figures

FIGURE 1 shows emission spectrum of YAG:Ce,Tb,Eu phosphor as discussed in Example 1. The excitation was at 450 nm.
FIGURE 2 shows emission spectrum of LuAG:Ce,Tb,Eu phosphor as discussed in Example 2. The excitation was at 450 nm.
FIGURE 3 shows emission spectrum of YAGG:Ce,Tb,Eu phosphor as discussed in Example 3. The excitation was at 450 nm.
FIGURE 4 shows emission spectrum of LuAGG:Ce,Tb,Eu phosphor as discussed in Example 4. The excitation was at 450 nm.
FIGURE 5 shows emission spectrum of YAGG:Ce,Tb,Eu and LuAGG:Ce phosphor mixture as discussed in Example 5. The excitation was at 450 nm.
FIGURE 6 shows a simulated emission spectrum of a combination of LuAG:Ce, YAG:Eu and a 450 nm pump LED, which had a CCT of 6000 K and a CRI of 87 as discussed in Example 7.
FIGURE 7 shows a simulated emission spectrum of a combination of LuAG:Ce, YAG:Eu and a 450 nm pump LED, which had a CCT of 3000 K and a CRI of 79, as discussed in Example 7.
FIGURE 8 shows a simulated emission spectrum of a combination of YAG:Ce, YAG:Eu and a 450 nm pump LED, which had a CCT of 3000 K and a CRI of 68, as discussed in Example 7.
FIGURE 9 shows the emission spectrum of Example 8, which had a CCT of 3112 K and a CRI of 66.
FIGURE 10 shows the emission spectrum of Example 9, which had a CCT of 5575 K and a CRI of 80.

### Summary of the invention

There is provided a phosphor ceramic comprising a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1, and wherein 0≤w<1.

It has been found that the phosphor ceramic is particularly suitable for high-power applications where high quality (color rendering index above 70) white light is desired, due to the combination of yellow/green, and red emitters. Furthermore, as the dopant ions are within a single material, the phosphors are more evenly dispersed. The ceramic form is a good heat conductor, thus preventing thermal quenching and degradation of the phosphors. The combination of effective light conversion and reduced thermal quenching results in a more energy efficient phosphor ceramic.

There is also provided a method for producing such a phosphor ceramic comprising the steps of A method for producing a phosphor ceramic, comprising the steps of:
a. providing a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1; and wherein 0≤w<1;
b. forming it into a shape; and
c. sintering the formed shape.

The method allows to produce the high-quality phosphor ceramic in a straightforward manner.

### Detailed description

The term "phosphor" according to the present invention refers to or encompasses in particular a material which upon suitable excitation, preferably in the blue, violet, UV-A or UV-B range (i.e., in particular 280-490 nm), emits light, in particular within a wavelength range of 400 - 2500 nm (visible and infrared spectrum).

The term "phosphor ceramic" according to the present invention in particular refers to a ceramic which essentially consists of light emitting materials.

The term "ceramic" according to the present invention refers to and/or encompasses in particular a compact crystalline or polycrystalline material which includes a controlled amount of pores or is nonporous.

The term "polycrystalline material" according to the present invention refers to and/or encompasses in particular a material having a bulk density of greater than 90 percent of the main component, consisting of more than 80 percent of individual crystal domains, wherein each crystal domain has a diameter of 0.01 - 150 µm and a different crystallographic orientation. The individual crystal domains may be bonded to each other or diluted via an amorphous or glassy material or by additional crystalline phases.

There is provided a phosphor ceramic comprising a garnet material having the composition of (A_{1-x-y-z}CeₓTb_{y}Eu_{z})₃(Al_{1-w}Ga_{w})₅O₁₂, wherein 0<x≤0.03, 0.2<y≤0.9, and 0<z≤0.05, and x+y+z≤1; and wherein 0≤w<1. A comprises at least one selected from the group consisting of Y, Gd, La, Lu, Sc, and Sm. Thus, the garnet material has a composition of a A₃Al₅O₁₂ garnet, wherein A is partially substituted with Ce, Tb and Eu; and Al may be partially substituted with Ga.

Preferably, A is Y and/or Lu.

The amount of Ce doping, x, is higher than 0, and equal to or less than 0.03. Low Ce-doping may result in not enough Ce-emission to absorb the desirable fraction of excitation light, thus preferably x is larger or equal to 0.0005. High Ce-doping can cause metal-to-metal charge transfer quenching between Ce and Eu, resulting in lower quantum yield. High Ce-doping may also cause back transfer from Tb to Ce. Therefore, x is preferably less than or equal to 0.003. Preferably, 0.0005≤x≤0.003.

The amount of Tb doping, y, is more than 0.2, and equal to or less than 0.9. In addition to showing good emission for desirable colour properties, Tb increases the energy transfer from Ce to Eu. Therefore, y is preferably more than or equal to 0.3. Too much Tb can result in back transfer from Tb to Ce, and a lower quantum yield due to concentration quenching. Thus, preferably y is less than or equal to 0.85. Preferably, 0.3≤y≤0.85.

The amount of Eu doping, z, is higher than 0 and equal to or less than 0.05. Eu is red emitting, and thus it is important for the generation of warm white light. Therefore, z is preferably equal to or more than 0.001. High Eu doping can cause metal-to-metal charge transfer quenching between Ce and Eu, resulting in lower quantum yield. Therefore, preferably z is equal to or less than 0.01. Preferably, 0.001≤z≤0.01.

The total amount of doping cannot be higher than 1. It has been found that the use of these dopants in these ratios allows for good conversion rate in high-power applications, and good color properties.

The amount of Ga doping, w, is equal to or greater than 0, and less than 1. It has been found that the inclusion of Ga allows increased Eu-emission and reduced Ce-emission, by reducing Tb to Ce back transfer. which may improve the color properties. Preferably, 0.2≤w≤0.6.

In an embodiment, the phosphor ceramic comprises a second garnet material having the composition of ((Y,Lu)₁₋ₐ(Ce)ₐ)₃(Al(_{1-b})Ga_{b})₅O₁₂, wherein 0<a≤0.02; and 0≤b<1. Thus, the second garnet material has a composition of a (Y,Lu)₃Al₅O₁₂ garnet, partially doped with Cerium on the Y,Lu position, and wherein Al may be partially substituted with Ga. The second garnet material comprises only Ce as its emitter ion, which allows to tune the Cerium emission intensity of the final phosphor ceramic. Due to the similar nature of the first garnet material and the second garnet material, these can be easily combined in a single ceramic.

The amount of Ce doping of the second garnet material, a, is higher than 0 and equal to or less than 0.02. Preferably, 0.0005≤a≤0.01. The amount of Ga doping, b, is equal to or greater than 0, and less than 1. Preferably, 0≤b≤0.6.

The phosphor ceramic is preferably a translucent ceramic, having a percent in-line transmittance of less than about 50%, as measured using a double beam spectrophotometer in the visible (420-700 nm for example) for a ceramic sample of 0.2 mm. Preferably, the in-line transmittance is about 0%-20% for a ceramic sample of 0.2 mm. The translucency is obtained from scattering within the ceramic.

The phosphor ceramic further has a quantum yield of at least 60%, preferably more than 70%, more preferably more than 80%, as measured for a ceramic sample of 0.2 mm thickness, irradiated with 450 nm light at 1 W/mm².

The phosphor ceramic may further comprise any optical ceramic additive known in the art. Preferably, the additive is selected from the group of scattering aids, thermal conductivity enhancers, or fluxes. More preferably, the additive is selected from the group consisting of alumina, silica and magnesia. These additives have a very high thermal conductivity, and thus may enhance the thermal conductivity of the entire ceramic. A high thermal conductivity gives cooler ceramics at the operating conditions of the devices, which lead to better conversion efficiencies. Furthermore, they may add as a flux in ceramic sintering. Preferably, the phosphor ceramic comprises about 0.5 wt% or less silica. In this amount, the silica helps in achieving higher densification in traditional garnet ceramics. Alumina may also improve scattering, and thus function as a scattering aid.

The phosphor ceramic preferably has a volume density larger than 90 percent of the theoretical maximum density, as measured using an electronic densimeter (MD-300s) supplied with an Alfa Mirage balance at room temperature by using the principle of Archimedes and water as buoyancy liquid.. A high density is desirable for thermal conductivity, and for the strength of the ceramic.

Preferably, the phosphor ceramic has a thickness of > 0.1 mm to ≤ 2.0 mm. Thickness is defined as the shortest distance through the phosphor ceramic. These dimensions are suitable for use in light emitting devices, as this is commonly the thickness needed to achieve a desired fraction of wavelength conversion. The phosphor ceramic shows good optical properties within these dimensions. In an embodiment, the phosphor ceramic is in the shape of a plate having a diameter to thickness ratio of more than 5:1.

Preferably, the phosphor ceramic is a polycrystalline material consisting of more than 80 percent by weight of single crystal domains, with each domain having a diameter of less than about 150 µm, and more than about 10 nm.

### Preparation method

There is provided a method for producing a phosphor ceramic, comprising the steps of:
a. providing a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1; and wherein 0≤w<1;
b. forming the garnet material into a shape; and
c. sintering the formed shape.

The method allows to prepare the phosphor ceramic of the invention.

Step a. comprises providing a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1; and wherein 0≤w<1.

In an embodiment, step a. comprises providing a further garnet material having the composition of ((Y,Lu)₁₋ₐ(Ce)ₐ)₃(Al(_{1-b})Ga_{b})₅O₁₂, wherein 0<a≤0.02, preferably 0.0005≤a≤0.01; and 0≤b<1, preferably 0≤b<0.6.

In an embodiment, the garnet material is in the form of particles having a diameter of less than about 10 micrometer, and more than about 100 nm; and/or the further garnet material is in the form of particles having a diameter of less than about 10 micrometer, and more than about 100 nm. Such particles are easy to source and allow to obtain the desired grain size and opacity.

In an embodiment, the garnet material is in the form of particles having a diameter of less than about 100 nm, and more than about 2 nm; and/or the further garnet material is in the form of particles having a diameter of less than about 100 nm, and more than about 2 nm. The use of nanoparticles allows for easier mixing of the garnet materials, lower sintering temperatures, and a higher density.

Step b. comprises forming the garnet material into a shape. Step b. may comprise any known way to form a garnet material into a shape. For example, step b. comprises axial and/or cold isostatic pressing, tape casting, slot die processes and/or thermoplastic processes (e.g. injection molding, hot casting (low-pressure or medium-pressure injection molding), and/or extruding). Preferably step b. is carried out such that the compression process takes place at pressures between > 20 and < 200 MPa.

Step c. comprises sintering the formed shape. This step allows to form the ceramic from the garnet material. Preferably, said sintering comprises heating at a temperature of 1200 - 1800°C, for 4 - 6 hours. When the garnet material and/or the further garnet material is in the form of particles having a diameter of less than about 10 micrometer, and more than about 100 nm, said sintering preferably comprises heating at a temperature of 1400 - 1800°C, for 4 - 6 hours, more preferably heating at about 1600 °C for about 4 hours. When the garnet material and/or the further garnet material is in the form of particles having a diameter of less than about 100 nm and more than about 2 nm, said sintering preferably comprises heating at a temperature of 1200- 1600 °C, for 4 - 6 hours, more preferably about 1500 °C for about 4 hours. Preferably the sintering is done in a low pressure atmosphere of 10⁻³ mbar or less.

The method may further comprise recompressing the sintered ceramic by hot isostatic pressing, and/or reworking the sintered ceramic, in particular by an ion beam preparation process or by a mechanical machining or fine grinding process with use of a defined or undefined cutting edge. When hot isostatic pressing, preferably this is carried out such that the recompression takes place at pressures between > 120 and < 180 MPa, preferably > 140 and < 160 MPa.

The method preferably further comprises heating the sintered ceramic in air atmosphere at 1000 °C - 1300 °C. Such a post-annealing avoids darkening of sintered body.

This method has proved to be useful because in this way a suitable phosphor ceramic can be produced easily in most applications.

There is further provided a light emitting device. The light emitting device comprises the phosphor ceramic of the invention.

Preferably, the light emitting device further comprises a light-emitting diode or a laser diode having an emission intensity of at least 1 W/mm². It has been found that the phosphor ceramic of the invention performs well under such high-power conditions.

Preferably, the light-emitting diode or the laser diode emits in the UV-A, violet or blue. These wavelengths are able to suitably excite Ce³⁺ in the phosphor ceramic. More preferably, the light-emitting diode or the laser diode emits in the blue, which allows to combine the blue light emission with the converted light emission, allowing to obtain good colour rendering in an efficient manner.

The phosphor ceramic according to the invention can be used in a variety of specific topological structures or applications, including - but not limited thereto - the following:
1. "Direct deposited phosphor ceramic":
   The phosphor ceramic is applied directly as a thin plate onto an LED dice, sometimes using an intermediary bonding material, such as silicone, sol-gel, or glass.
2. "Remote phosphor" systems:
   "Remote phosphor" systems in particular mean devices in which a phosphor is arranged remote from a light-emitting light source emitting in a narrow wavelength range, usually embedded in or linked to a polymer, glass or ceramic matrix. Thus, a remote phosphor system is fundamentally different from a system in which the phosphor is applied directly onto or at the light source such as in LED light sources in which the phosphor is applied directly onto the light-emitting dice. Usually, a distinction is made between two basic structures, from which many variants can be derived: a) "Remote phosphor in transmission application": The phosphor matrix is placed onto a reflection chamber in which the LED is disposed. The light can escape only through the phosphor matrix (transmission). b) "Remote phosphor in reflection mode application": The phosphor matrix is applied onto a reflective carrier or is coated with a reflective material on the back side, the LED light source is disposed in or slightly sideward from the emission direction and irradiates onto the phosphor matrix. The converted light is re-emitted in the direction of the light source
or in the radiation direction, the light which has passed through the phosphor matrix light is directed by means of the back side reflective layer again through the phosphor matrix in the emission direction. Thus, the light can only escape in the reflection direction. According to a preferred embodiment of the present invention, within the inventive light emitting system, the ceramic phosphor may be optically coupled to an LED chip. Such an LED chip may be one based on the III-V nitride material system. For example, the LED chip may comprise a GaInN based active region between n-type and p-type GaN layers which have been deposited on a suitable substrate (e.g., sapphire, silicon carbide, silicon, Ga203, or GaN itself) by known methods such as metal organic chemical vapor deposition (MOCVD) or molecular beam epitaxy (MBE).

Optical coupling from the LED active region to the ceramic phosphor may be made via the substrate (in the case of a transparent substrate and a flip-chip mounting configuration) or the epitaxial layers (in the case of substrate-down mounting, or if the substrate has been removed as is the case for thin-film-flip-chip LED architectures). The ceramic phosphor may be physically attached to the LED chip, typically by a transparent adhesive such as a silicone adhesive.

Alternatively, the ceramic phosphor may be mounted remotely from the LED chip. Optical materials are provided to help direct and/or mix the primary light from the LED chip and that emitted by the ceramic phosphor. For example, silicone may be loaded with a reflective material (e.g. titania) and may be applied to surround the sides of the LED chip and ceramic phosphor, so that substantially all light emission is through the top surface of the ceramic phosphor. This has the benefit of increasing luminance as well as that of homogenizing color uniformity.

The LED chip may be mounted in a package, such as a ceramic package or lead- frame based package, to provide mechanical stability and/or handling capability, as well as thermal dissipation means. In addition, the package may provide a stage for the application of a lens which surrounds the LED chip including the ceramic phosphor. Such a lens may be made of transparent silicone and shaped in the form of a dome which assists with light-outcoupling from the ceramic phosphor. Electrical current is supplied to the LED chip via electrodes within the package that are electrically connected to ohmic contact materials applied to n- and p-type layers within the LED chip. Portions of this current are converted to light generation within the LED active region. Depending on the detailed design of the LED active region, the primary light emission wavelength range may be tuned. For example, for GaInN, this range of tenability can be from the UV-A to throughout the visible spectrum. In particular, the primary emission wavelength may be selected to interact with the ceramic phosphor in a desirable way, for example, to provide a certain chromaticity of emitted light with certain color rendering characteristics.

One or more packaged LEDs as described above, which includes the LED chip and ceramic phosphor, may be used as part of a lighting system. Such a lighting system might be a lighting module, lamp, or luminaire. A lighting module might comprise a plurality of packaged LEDs and include additional means for light conditioning (optics) as well as thermal management (passive or active heatsinking means). Optionally, a module might further include electrical driving means for supplying target current and voltage levels to the LED(s) from a primary mains or battery power source. A lamp is usually formed in a standard housing form factor, and typically includes, in addition to the LED(s), electrical driving means to couple to mains power through a standard socket interface. Similarly, a luminaire has a housing and typically includes, in addition to the LED(s), electrical driving means to couple to mains power. In addition, sensing and/or communication electronics may be included into the lighting system.

There is further provided the use of the phosphor ceramic of the invention in high-power applications. It has been found that the phosphor ceramic of the invention performs well under such high-power applications, due to the improved Eu³⁺ emission and thermal conductivity.

The invention may further be defined in the following clauses:
1. A phosphor ceramic comprising a garnet material having the composition of (A_{1-x-y-z}CeₓTb_{y}Eu_{z})₃(Al₁-_{w}Ga_{w})₅O₁₂, wherein A comprises at least one selected from the group consisting of Y, Gd, La, Lu, Sc, and Sm;
   wherein 0<x≤0.03, 0.2<y≤0.9, and 0<z≤0.05, and x+y+z≤1,
   wherein 0≤w<1.
2. The phosphor ceramic of any preceding clause, wherein 0.000≤x≤0.003, 0.3≤y≤0.85, and/or 0.001≤z≤0.01.
3. The phosphor ceramic of any preceding clause, wherein A comprises Y and/or Lu.
4. The phosphor ceramic of any preceding clause, further comprising a second garnet material having the composition of ((Y,Lu)₁₋ₐ(Ce)ₐ)₃(Al(_{1-b})Ga_{b})₅O₁₂, wherein 0<a≤0.02, preferably 0.0005≤a≤0.01; and 0≤b<1.
5. The phosphor ceramic of any preceding clause, where 0.2≤w≤0.6, and/or wherein 0≤b≤0.6.
6. The phosphor ceramic of any preceding clause, which:
   - is a translucent ceramic having an inline transmittance %T for a thickness of 0.2 mm of less than about 50%, preferably about 0 to about 20%;
   - has a quantum yield of at least 60%, preferably more than 70%, more preferably more than 80%, as measured for a ceramic sample of 0.2 mm thickness, irradiated with 450 nm light at 1 W/mm²;
   - has a volume density larger than 90 percent of the theoretical maximum density; and/or
   - further comprises one or more additives selected from scattering aids, thermal conductivity enhancers, and fluxes, preferably wherein said additive is selected from alumina, silica or magnesia.
7. The phosphor ceramic according to clause 6, having a thickness of ≥ 0.1 mm to ≤ 2.0 mm.
8. The phosphor ceramic of any preceding clause, which is a polycrystalline material consisting of more than 80 percent by weight of single crystal domains, with each domain having a diameter of less than about 150 µm, and more than about 10 nm.
9. A method for producing a phosphor ceramic, comprising the steps of:
   a. providing a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1; and wherein 0≤w<1;
   b. forming it into a shape; and
   c. sintering the formed shape.
10. The method according to clause 7, wherein step a. comprises providing a further garnet material having the composition of ((Y,Lu)₁₋ₐ(Ce)ₐ)₃(Al(_{1-b})Ga_{b})₅O₁₂, wherein 0<a≤0.02, preferably 0.0005≤a≤0.01; and 0≤b<1, preferably 0≤b<0.6.
11. The method according to clause 9 or 10, wherein the garnet material is in the form of particles having a diameter of less than about 10 micrometer, and more than about 100 nm; and/or
   the further garnet material is in the form of particles having a diameter of less than about 10 micrometer, and more than about 100 nm.
12. The method according to clause 9 or 10, wherein the garnet material is in the form of particles having a diameter of less than about 100 nm, and more than about 2 nm; and/or
   the further garnet material is in the form of particles having a diameter of less than about 100 nm, and more than about 2 nm.
13. The method according to any of clauses 9-12, wherein said b. comprises axial and/or cold isostatic pressing, tape casting, slot die processes and/or thermoplastic processes (e.g. injection molding, hot casting (low-pressure or medium-pressure injection molding), and/or extruding), wherein preferably step b. is carried out such that the compression process takes place at pressures between > 20 and < 200 MPa.
14. The method according to any of clauses 9-13, wherein c. comprises heating at a temperature of 1200 - 1800°C, for 4 - 6 hours, preferably in a low pressure atmosphere of 10⁻³ mbar or less.
15. The method according to clause 14, wherein the garnet material and/or the further garnet material is in the form of particles having a diameter of less than about 10 micrometer, and more than about 100 nm, and said sintering comprises heating at a temperature of 1400 - 1800°C, for 4 - 6 hours, preferably heating at about 1600 °C for about 4 hours.
16. The method according to clause 14, wherein the garnet material and/or the further garnet material is in the form of particles having a diameter of less than about 100 nm and more than about 2 nm, and said sintering comprises heating at a temperature of 1200 - 1600 °C, for 4 - 6 hours, preferably about 1500 °C for about 4 hours.
17. The method according to any of clauses 9-16, further comprising heating the sintered ceramic in air atmosphere at 1000 °C - 1300 °C.
18. A light emitting device comprising the phosphor ceramic of clauses 1-8, preferably further comprising a light-emitting diode or laser diode having an emission intensity of at least 1 W/mm².
19. A light emitting device according to clause 18, wherein the light-emitting diode or laser diode emits in the UV-A or blue.
20. Use of the phosphor ceramic material of clauses 1-8 in high-power applications.

### Examples

### Comparative Example A: Ce³⁺, Tb³⁺ co-doped YAG

YAG:0.1%Ce, 76.8%Tb phosphor powder was prepared by weighing 0.27 g Yttrium nitrate hydrate, 1.875 g Aluminum nitrate hydrate, 0.0013 g Cerium nitrate hydrate, 1.00 g Terbium nitrate hydrate and 0.6 g urea. All the chemicals were dissolved in 5 ml deionized water. The solution was then heated and allowed to boil until a foamy mass was achieved. The foam was ground and transferred to an alumina crucible. Baking was done at 1000 °C in air for 2 hrs. The sample was ground again and baked at 1500 °C in air for 4 hrs. A yellow colored powder sample was achieved.

The Ce, Tb co-doped YAG showed broad Ce emission under 450 nm excitation. The emission did not exhibit any Tb peaks due to Tb³⁺ → Ce³⁺ energy back-transfer.

### Example 1: Ce³⁺, Tb³⁺, Eu³⁺ co-doped YAG

YAG:0.1%Ce, 76.8%Tb, 0.2% Eu phosphor powder was prepared by weighing 0.265 g Yttrium nitrate hydrate, 1.875 g Aluminum nitrate hydrate, 0.0013 g Cerium nitrate hydrate, 1.00 g Terbium nitrate hydrate, 0.0027 g Europium nitrate hydrate and 0.6 g urea. All the chemicals were dissolved in 5 ml deionized water. The solution was then heated and allowed to boil until a foamy mass was achieved. The foam was ground and transferred to an alumina crucible. Baking was done at 1000 °C in air for 2 hrs. The sample was ground again and baked at 1500 °C in air for 4 hrs. A yellow colored powder sample was achieved.

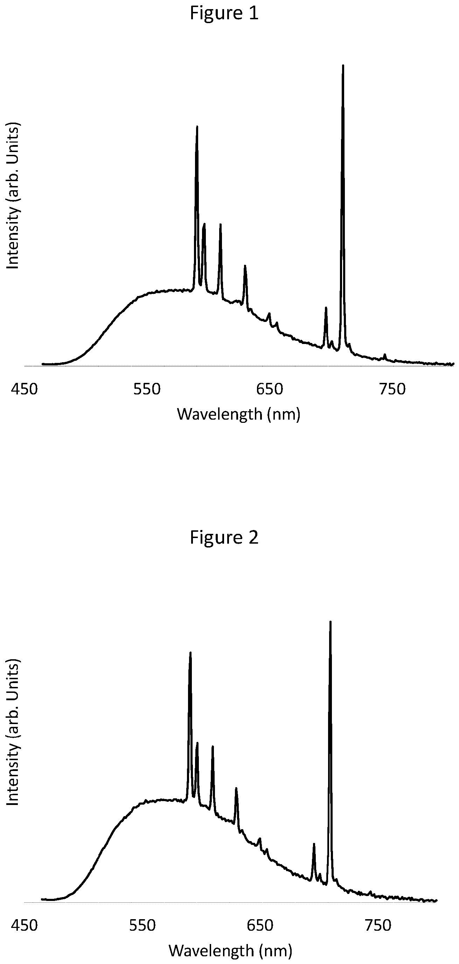

The Ce, Tb, Eu co-doped YAG showed broad Ce emission together with intense Eu line emission under 450 nm excitation (Figure 1).

### Example 2: Ce³⁺, Tb³⁺, Eu3+ co-doped LuAG

LuAG:0.1%Ce, 76.8%Tb, 0.2% Eu phosphor powder was prepared by weighing 0.30 g Lutetium nitrate hydrate, 1.875 g Aluminum nitrate hydrate, 0.0013 g Cerium nitrate hydrate, 1.00 g Terbium nitrate hydrate, 0.0027 g Europium nitrate hydrate and 0.6 g urea. All the chemicals were dissolved in 5 ml deionized water. The solution was then heated and allowed to boil until a foamy mass was achieved. The foam was ground and transferred to an alumina crucible. Baking was done at 1000 °C in air for 2 hrs. The sample was ground again and baked at 1500 °C in air for 4 hrs. A yellow colored powder sample was achieved.

The Ce, Tb, Eu co-doped LuAG showed broad Ce emission together with intense Eu line emission under 450 nm excitation (Figure 2).

### Example 3: Ce³⁺, Tb³⁺, Eu³⁺ co-doped YAGG

YAGG:0.1%Ce, 76.8%Tb, 0.2% Eu phosphor powder with 45% Gallium at Aluminum site was prepared by weighing 0.265 g Yttrium nitrate hydrate, 1.032 g Aluminum nitrate hydrate, 0.94 g gallium nitrate hydrate, 0.0013 g Cerium nitrate hydrate, 1.00 g Terbium nitrate hydrate, 0.0027 g Europium nitrate hydrate and 0.6 g urea. All the chemicals were dissolved in 5 ml deionized water. The solution was then heated and allowed to boil until a foamy mass was achieved. The foam was ground and transferred to an alumina crucible. Baking was done at 1000 °C in air for 2 hrs. The sample was ground again and baked at 1500 °C in air for 4 hrs. A yellow colored powder sample was achieved.

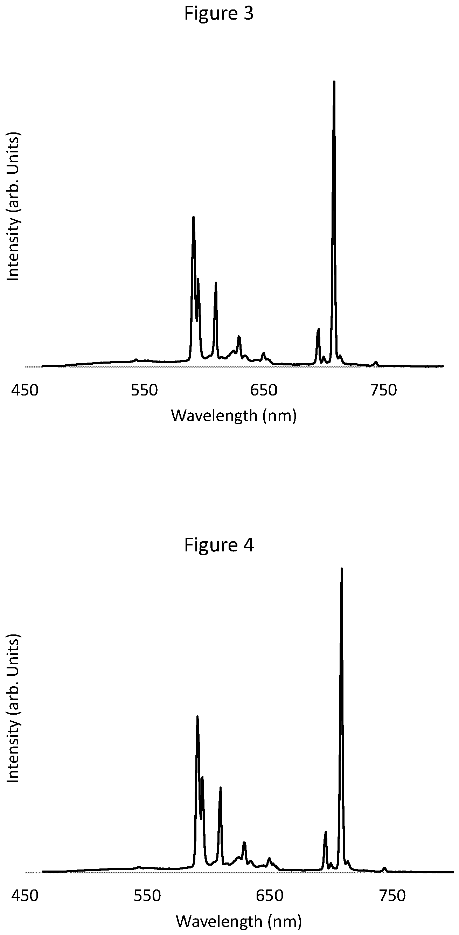

The Ce, Tb, Eu co-doped YAGG showed intense Eu line emission under 450 nm excitation (Figure 3). The broad Ce emission was very weak as most of the energy was transferred to Eu via Tb intermediate.

### Example 4: Ce³⁺, Tb³⁺, Eu³⁺ co-doped LuAGG

LuAGG:0.1%Ce, 76.8%Tb, 0.2% Eu phosphor powder with 45% Gallium at Aluminum site was prepared by weighing 0.30 g Yttrium nitrate hydrate, 1.032 g Aluminum nitrate hydrate, 0.94 g gallium nitrate hydrate, 0.0013 g Cerium nitrate hydrate, 1.00 g Terbium nitrate hydrate, 0.0027 g Europium nitrate hydrate and 0.6 g urea. All the chemicals were dissolved in 5 ml deionized water. The solution was then heated and allowed to boil until a foamy mass was achieved. The foam was ground and transferred to an alumina crucible. Baking was done at 1000 °C in air for 2 hrs. The sample was ground again and baked at 1500 °C in air for 4 hrs. A yellow colored powder sample was achieved.

The Ce, Tb, Eu co-doped LuAGG showed intense Eu line emission under 450 nm excitation (Figure 4). The broad Ce emission had disappeared as all energy was transferred to Eu via Tb intermediate.

### Example 5: Ce³⁺, Tb³⁺, Eu³⁺ co-doped YAGG - Ce³⁺ doped LuAGG mixed phosphors

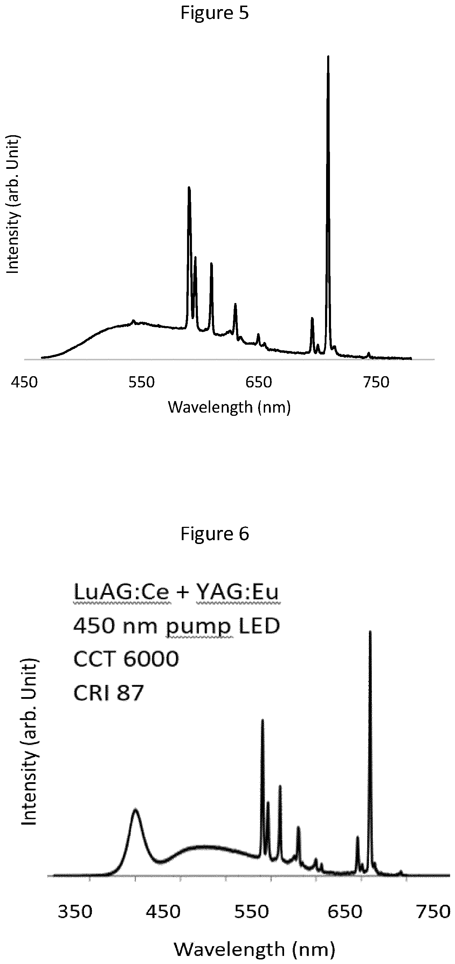

YAGG:0.1%Ce, 60%Tb, 0.2% Eu phosphor powder with 20% Gallium at Aluminum site was prepared by following the above procedure. Similarly, LuAGG: 0.5% Ce phosphor powder with 20% gallium at aluminum site was prepared. The Ce, Tb, Eu co-doped YAGG showed broad Ce emission and intense Eu line emission under 450 nm excitation. The Ce doped LuAGG showed broad blue-green emission under 450 nm excitation. The Ce, Tb, Eu co-doped YAGG and Ce-doped LuAGG phosphors were mixed in 5:1 ratio, respectively. The mixed phosphor emission covers broad spectral range required for achieving high CRI white LED emission (Figure 5).

### Example 6: Mixed-phosphor ceramic

The Ce, Tb, Eu co-doped YAGG and Ce doped LuAGG phosphor mixture as prepared in example 5 was mixed with TEOS such that the final silica contents was around 1%. The powder was uniaxially pressed with 10 ton loading to form a thin pellet (^{∼}0.5 mm thickness). The pellet was then annealed at 1400°C for 4 h in nitrogen atmosphere to achieve a mixed phosphor ceramic. The emission spectrum of the pellet made in this example shows a similar spectral profile as the phosphor powder described in Example 5 (Figure 5).

### Example 7: Simulated spectra

The emission spectrum obtained from Example 4 was combined with the LuAGG:Ce spectrum of Example 5 and a YAG:Ce emission spectrum, obtained by measuring a commercially obtained YAG:Ce (3%) sample, and that of a 450 nm LED to provide simulated spectra.

In a first simulation, the Example 4 spectrum, the emission spectrum of LuAG:Ce and that of a 450 nm LED were combined such that a CCT of 6000 K was achieved. The combined simulated spectrum showed a CRI of 87 (Figure 6).

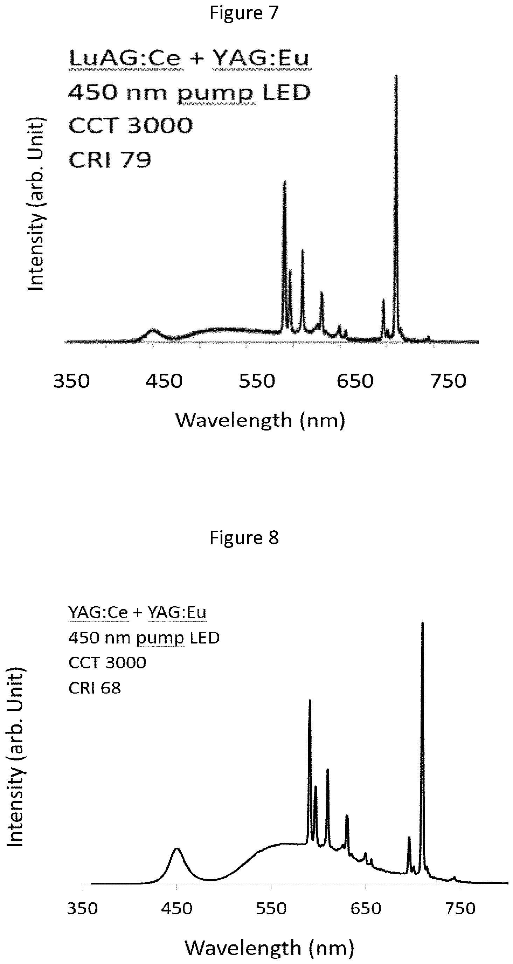

In a second simulation, the Example 4 spectrum, the emission spectrum of LuAG:Ce and that of a 450 nm LED were combined such that a CCT of 3000 K was achieved. The combined simulated spectrum showed a CRI of 79 (Figure 7).

In a third simulation, the Example 4 spectrum, the emission spectrum of YAG:Ce and 450 nm LED were combined such that a CCT of 3000 K was achieved. The combined simulated spectrum showed a CRI of 68 (Figure 8).

### Example 8: LED spectrum

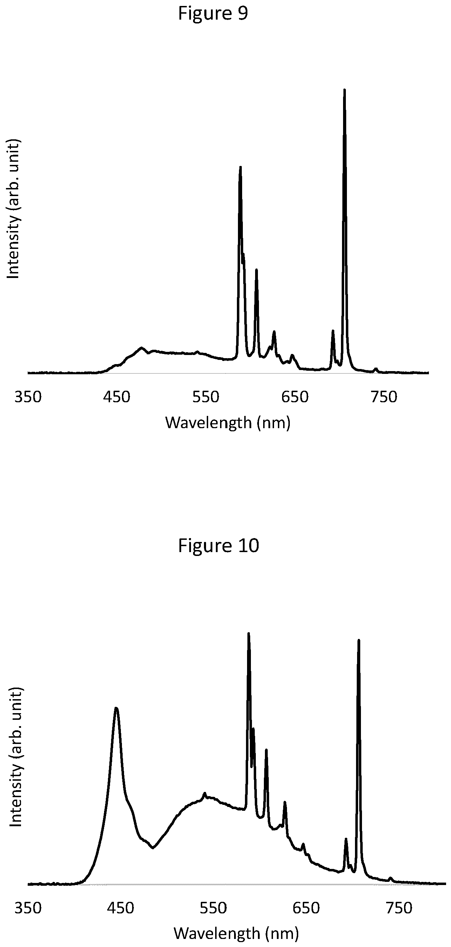

The material of Example 4 was mixed with LuAG:Ce, and mixed in silicone. Then, a droplet was put on a 450 nm LED chip, where the thickness was adjusted until the spectrum was on the black body line of the CIE 1931 xy chromaticity diagram. The spectrum showed a correlated color temperature of 3112 K and a CRI of 66 (Figure 9).

### Example 9: LED spectrum

The mixed phosphor material of Example 5 was mixed in silicone. Then, a droplet was put on a 450 nm LED chip, where the thickness was adjusted until the spectrum was on the black body line of the CIE 1931 xy chromaticity diagram. The spectrum showed a correlated color temperature of 5575 K and a CRI of 80 (Figure 10).

## Claims

1. A phosphor ceramic comprising a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm;
wherein 0<x≤0.03, 0.2<y≤0.9, and 0<z≤0.05, and x+y+z≤1,
wherein 0≤w<1.

2. The phosphor ceramic of any preceding claim, wherein 0.0005≤x≤0.003, 0.3≤y≤0.85, and/or 0.001≤z≤0.01.

3. The phosphor ceramic of any preceding claim, wherein A comprises Y and/or Lu.

4. The phosphor ceramic of any preceding claim, further comprising a second garnet material having the composition of ((Y,Lu)₁₋ₐ(Ce)ₐ)₃(Al(_{1-b})Ga_{b})₅O₁₂, wherein 0<a≤0.02, preferably 0.0005≤a≤0.01; and 0≤b<1.

5. The phosphor ceramic of any preceding claim, where 0.2≤w≤0.6, and/or wherein 0≤b≤0.6.

6. The phosphor ceramic of claim any preceding claim, which:
- is a translucent ceramic having an inline transmittance %T for a thickness of 0.2 mm of less than about 50%, preferably about 0 to about 20%;
- has a quantum yield of at least 60%, preferably more than 70%, more preferably more than 80%, as measured for a ceramic sample of 0.2 mm thickness, irradiated with 450 nm light at 1 W/mm²;
- has a volume density larger than 90 percent of the theoretical maximum density; and/or
- further comprises one or more additives selected from scattering aids, thermal conductivity enhancers, and fluxes, preferably wherein said additive is selected from alumina, silica or magnesia.

7. The phosphor ceramic according to claim 6, having a thickness of ≥ 0.1 mm to ≤ 2.0 mm.

8. The phosphor ceramic of any preceding claim, which is a polycrystalline material consisting of more than 80 percent by weight of single crystal domains, with each domain having a diameter of less than about 150 µm, and more than about 10 nm.

9. A method for producing a phosphor ceramic, comprising the steps of:
a. providing a garnet material having the composition of (A_{1-x-y-z}CeₓTb_{y}Eu_{z})₃(Al_{1-w}Ga_{w})₅O₁₂, wherein A comprises at least one selected from the group consisting of Y, Gd, La, Lu, Sc, and Sm; wherein 0<x≤0.03, 0.2<y≤0.9, and 0<z≤0.05, and x+y+z≤1; and wherein 0≤w<1;
b. forming it into a shape; and
c. sintering the formed shape.

10. The method according to claim 7, wherein step a. comprises providing a further garnet material having the composition of ((Y,Lu)₁₋ₐ(Ce)ₐ)₃(Al(_{1-b})Ga_{b})₅O₁₂, wherein 0<a≤0.02, preferably 0.0005≤a≤0.01; and 0≤b<1, preferably 0≤b<0.6.

11. The method according to claim 9 or 10, wherein the garnet material is in the form of particles having a diameter of less than about 10 micrometer, and more than about 100 nm; and/or
the further garnet material is in the form of particles having a diameter of less than about 10 micrometer, and more than about 100 nm.

12. The method according to claim 9 or 10, wherein the garnet material is in the form of particles having a diameter of less than about 100 nm, and more than about 2 nm; and/or
the further garnet material is in the form of particles having a diameter of less than about 100 nm, and more than about 2 nm.

13. A light emitting device comprising the phosphor ceramic of claims 1-8, preferably further comprising a light-emitting diode or laser diode having an emission intensity of at least 1 W/mm².

14. A light emitting device according to claim 12, wherein the light-emitting diode or laser diode emits in the UV-A or blue.

15. Use of the phosphor ceramic material of claims 1-8 in high-power applications.
